(19) Europäisches Patentamt
European Patent Office
Office européen des brevets

(11) **EP 2 669 718 B1**

(12) **EUROPÄISCHE PATENTSCHRIFT**

(45) Veröffentlichungstag und Bekanntmachung des Hinweises auf die Patenterteilung:
**28.12.2016  Patentblatt 2016/52**

(51) Int Cl.:
**G02B 5/20** (2006.01)     **C23C 14/06** (2006.01)
**G02F 1/1335** (2006.01)     **G02B 5/22** (2006.01)

(21) Anmeldenummer: **13165729.8**

(22) Anmeldetag: **29.04.2013**

(54) **Licht absorbierende Schichtstruktur**

Light absorbing layer structure

Structure stratifiée absorbant la lumière

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.06.2012  DE 102012010803**

(43) Veröffentlichungstag der Anmeldung:
**04.12.2013  Patentblatt 2013/49**

(73) Patentinhaber:
• **Heraeus Deutschland GmbH & Co. KG**
  **63450 Hanau (DE)**
• **Fraunhofer-Gesellschaft zur Förderung der angewandten Forschung e.V.**
  **80686 München (DE)**

(72) Erfinder:
• **Dewald, Wilma**
  **38106 Braunschweig (DE)**
• **Szyszka, Bernd**
  **38108 Braunschweig (DE)**
• **Kastner, Albert**
  **63457 Hanau (DE)**
• **Schneider-Betz, Sabine**
  **63303 Dreieich (DE)**
• **Schlott, Martin**
  **63075 Offenbach (DE)**
• **Schultheis, Markus**
  **36103 Flieden (DE)**
• **Wagner, Jens**
  **60322 Frankfurt (DE)**

(74) Vertreter: **Staudt, Armin Walter**
  **Sandeldamm 24a**
  **63450 Hanau (DE)**

(56) Entgegenhaltungen:
**US-A- 5 976 639     US-A1- 2010 313 875**
**US-B1- 6 366 012**

• **HIRAYAMA H ET AL: "13.3: INTEGRATED BLACK MATRIX ON TFT ARRAYS COMPOSED OF NEWLY DEVELOPED BI-SIOX CERMET THIN FILM", 1997 SID INTERNATIONAL SYMPOSIUM DIGEST OF TECHNICAL PAPERS. BOSTON, MAY 13 - 15, 1997; [SID INTERNATIONAL SYMPOSIUM DIGEST OF TECHNICAL PAPERS], SANTA ANA, SID, US, Bd. VOL. 28, 13. Mai 1997 (1997-05-13), Seiten 180-183, XP000722683,**

## Beschreibung

Technischer Hintergrund

Die vorliegende Erfindung betrifft eine Licht absorbierende, für einen Betrachter undurchlässig erscheinende Schichtstruktur umfassend eine dem Betrachter zugewandte vordere Schichtlage aus einer Matrix aus dielektrischem Metalloxid mit darin eingebetteten Partikeln aus elektrisch leitfähigem Werkstoff in einer ersten mittleren Konzentration, und eine dem Betrachter abgewandte hintere Schichtlage aus einer Matrix aus dem Metalloxid und darin eingebetteten Partikeln aus dem elektrisch leitfähigen Werkstoff in einer zweiten mittleren Konzentration, die höher ist als die erste mittlere Konzentration.

Stand der Technik

Lichtabsorbierende Schichten werden auf der Glasoberfläche von Kathodenstrahlrohren oder anderen hochauflösenden Bildanzeigen aufgebracht, wie etwa auf Flüssigkristallpanels. Die lichtabsorbierende Struktur wird auch als "Black-Matrix" bezeichnet. Sie vermindert Reflexionen von Umgebungslicht und verbessert den Kontrast, indem sie benachbarte lichtdurchlässige Bereiche unterschiedlicher Farben voneinander trennt oder die Dünnfilmtransistoren bei Aktiv-Matrix-Displays abdeckt und so optische Wechselwirkungen oder kontrastmindernde Reflexionen vermindert.

Die Black-Matrix-Struktur besteht im einfachsten Fall aus Graphit oder graphitisiertem Kohlenstoff. Im Zuge der Herstellung immer größerer, hochauflösender Bildanzeigen steigen jedoch die Anforderungen an die Black-Matrix-Schicht. Moderne Schichtstrukturen enthalten entweder gedruckte organische Absorber oder sind aus einem cermetartigen Schichtsystem auf der Basis von Cr, CrNx und CrOy aufgebaut. Auch für thermosolare Absorber werden schwarze Schichten benötigt. Auch hier werden sogenannte Cermets eingesetzt.

Diese bestehen aus einer dielektrischen oder elektrisch nicht leitfähigen Matrix, in die elektrisch leitfähige, in der Regel metallische Partikel eingelagert sind, die das in die Schicht einfallende Licht streuen.

Eine verbreitete Black-Matrix-Schichtstruktur besteht aus unterstöchiometrischem Chromoxid als Matrix mit ($CrO_x$) mit darin eingelagerten Chrompartikeln (Cr). Eine derartige Schichtstruktur, die im Folgenden auch in Kurzschreibweise als "$CrO_x$/Cr" oder "$CrO_x$ + Cr "bezeichnet werden kann, ist aus der US 5,976,639 A bekannt. Die bekannte Schicht ist dreilagig. Auf einem Glassubstrat werden eine untere Lage mit geringem Chromanteil, eine obere Lage mit hohem Chromanteil und eine Zwischenschicht zwischen unterer und oberer Lage mit allmählich zunehmendem Chromanteil aufgebracht. Die metallischen Chrompartikel streuen das vom Glassubstrat her einfallende Licht und dissipieren es vorwiegend in der oberen Lage der Schichtstruktur.

Chrom ist jedoch - insbesondere bei den im Herstellungsprozess erforderlichen Ätzprozessen - toxisch. Diesen Nachteil vermeidet eine chromfreie, optisch absorbierende Black-Matrix-Schicht gemäß der US 6,387,576 B2. Diese besteht aus dem dielektrischen Material SiO als Matrix, das zumindest ein weiteres Metall enthält, bei welchem es sich um Eisen, Kobalt, Vanadium oder Titan handelt. Dabei nimmt der Gehalt an SiO entlang der Einfallsrichtung des Lichts auf das Display ab, während der Gehalt des Metalls ansteigt. Die so erzeugten gradierten Schichten müssen eine Schichtdicke von mindestens 200 nm haben, um den optischen Anforderungen zu genügen, und deren Abscheidung im industriellen Fertigungsprozess ist schwierig.

Die Herstellung der absorbierenden Black-Matrix-Strukturen erfolgt beispielsweise mittels PVD-Techniken (Physical Vapor Deposition, im Folgenden auch bezeichnet als "Sputtern"). Beim Sputtern werden Atome oder Verbindungen aus einem Festkörper, dem Sputtertarget, durch Beschuss mit energiereichen Ionen (üblicherweise Edelgasionen) herausgelöst und gehen in die Gasphase über. Die in der Gasphase befindlichen Atome oder Moleküle werden schließlich durch Kondensation auf einem in der Nähe des Sputtertargets befindlichen Substrat abgeschieden und bilden dort eine Schicht aus. Beim "Gleichspannungssputtern" oder "DC-Sputtern" (direct current sputtering) wird zwischen dem als Kathode geschalteten Target und einer Anode (häufig das Anlagengehäuse) eine Gleichspannung angelegt. Durch Stoßionisation von Inertgasatomen bildet sich im evakuierten Gasraum ein Niederdruckplasma, dessen positiv geladene Bestandteile durch die angelegte Gleichspannung als dauerhafter Teilchenstrom in Richtung auf das Target beschleunigt werden und beim Aufprall Teilchen aus dem Target herausgeschlagen, die sich wiederum in Richtung auf das Substrat bewegen und sich dort als Schicht niederschlagen. Das DC-Sputtern ist nur für elektrisch leitfähige Targetmaterialien anwendbar, da sich andernfalls das Target infolge des dauerhaften Stroms elektrisch geladener Teilchen aufladen und damit das Gleichspannungsfeld kompensieren würden. Andererseits ist gerade diese Sputtermethode geeignet, Schichten besonders hoher Qualität auf wirtschaftliche Weise zu liefern, so dass ihr Einsatz angestrebt wird.

Licht absorbierende Schichtsysteme werden auch für solarthermische Anwendungen eingesetzt. Hierbei umfasst der Schichtaufbau typischerweise eine Cermetschicht und eine darunter liegende metallische Abschlussschicht, die als selektiver Reflektor dient. Die in die Cermetschicht eingelagerten leitfähigen oder metallischen Partikel haben Durchmesser von typischerweise 5-30 nm.

Diese Schichtstapel weisen im solaren Spektralbereich (um 350 bis 1500 nm) einen hohen Absorptionsgrad auf, während ihr Absorptionsgrad im infraroten Spektralbereich gering ist. Für ihre industrielle Fertigung sind galvanische Beschichtungstechniken und ebenfalls PVD-Verfahren gebräuchlich.

Beispiele für solche Schichtstapel sind Ni/NiO + Al und TiNx/TiO$_2$ + Cu. Eine aktuelle Übersicht gibt "Kennedy, C.E.; - Review of Mid- to High-Temperature Solar Selective Absorber Materials; NREL Technical Report (July 2002)".

Aus der US-A1-2010/0313875 ist eine weitere Schichtstruktur aus Cermet Schichten zur Beschichtung von Rohren für Solarabsorber bekannt. Der Schichtwiderstand wird nicht betrachtet.

Die als selektiver Reflektor dienende metallische Abschlussschicht zeigt ein optimales Absorptionsverhalten. Wegen ihrer hohen elektrischen Leitfähigkeit wirkt die jedoch stark dämpfend für darunter verlaufende Signalleitungen hochfrequenter elektronischer Schaltungen und ist daher für Anwendungen im Bereich der Hochfrequenztechnik oder überall dort, wo im Schichtsystem außerdem Signale schnell geschaltet werden müssen, nicht geeignet.

## Technische Aufgabenstellung

Aus dem zuletzt genannten Grund sind Schichtstrukturen erwünscht, die geringe Wechselwirkungen mit elektronischen Bauteilen und Signalleitungen zeigen, die also eine möglichst geringe elektrische Leitfähigkeit haben. Metallische Schichten oder Schichtlagen erfüllen diese Voraussetzung nicht.

Andererseits - und dazu im gewissen Widerspruch stehend - sollen die Schichten aus Qualitätserwägungen vorzugsweise durch DC-Sputtern herstellbar sein, was einen elektrisch leitenden Target-Werkstoff voraussetzt.

Ergänzend dazu soll die absorbierende Schichtstruktur vorzugsweise keine giftigen Substanzen enthalten, insbesondere kein Chrom.

## Allgemeine Beschreibung der Erfindung

Diese Aufgabe wird ausgehend von einem Sputtertarget der eingangs genannten Gattung erfindungsgemäß dadurch gelöst, dass das Metalloxid Nioboxid, Titanoxid, Molybdänoxid, Wolframoxid oder Vanadiumoxid enthält.

Die erfindungsgemäße Schichtstruktur weist mindestens zwei Schichtlagen auf, die jeweils als Cermet aus einer dielektrischen, möglichst hoch brechenden oxidischen Matrix sowie darin eingelagerten, elektrisch gut leitfähigen Metallpartikeln bestehen. Die dielektrische Eigenschaft der Matrix macht die Schichtstruktur insgesamt hochohmig, so dass Wechselwirkungen mit elektronischen Bauteilen in unmittelbarer Nähe vermieden werden.

Andererseits sollen die Schichtlagen durch DC-Sputtern herstellbar sein, was elektrisch leitfähiges Targetmaterial voraussetzt. Das Targetmaterial enthält die oxidische Phase und eine weitere Phase aus dem elektrisch gut leitenden Material.

Die beiden obigen Randbedingungen hinsichtlich Eigenschaft und Herstellung der Matrix sind erfüllbar, wenn als Targetmaterial ein Werkstoff eingesetzt wird, der außer dem elektrisch gut leitenden Material unterstöchiometrisches Oxid enthält, wie TiOx, Nb$_2$Ox, MoOx, WOx, VOx oder Mischungen davon. Diese Oxide weisen einen Sauerstoffmangel im Vergleich zur stöchiometrischen Zusammensetzung auf. Damit ist das Sputtertarget auch ohne elektrisch leitende Phase oder bei geringen Anteilen desselben ausreichend elektrisch leitfähig für das DC-Sputtern.

Beim DC-Sputtern sind die oben genannten unterstöchiometrischen Oxide in der Lage Sauerstoff aufzunehmen, so dass sie in aufoxidierter Form in den jeweiligen Schichtlagen die gewünschte dielektrische Eigenschaft, also elektrisch isolierende, hochohmige Matrix bilden. Die so erhaltene Schicht enthält somit eine Matrix aus TiO$_2$, Nb$_2$O$_5$, Mo$_2$O$_3$, W$_2$O$_3$, V$_2$O$_5$ oder Mischungen dieser hochbrechenden und dielektrischen Metalloxide mit stöchiometrischem oder allenfalls gering unterstöchiometrischem Sauerstoffgehalt.

Die Matrix wird von einem oder mehreren der oben genannten Metalloxide gebildet. Das bedeutet, dass Metalloxid zu mehr als 50 Vol.-% in den jeweiligen Schichtlagen vorliegt. Andererseits soll die Schichtstruktur für einen Betrachter optisch nicht transparent, also undurchsichtig erscheinen. Hierzu ist zumindest in der vom Betrachter aus gesehen hinteren Schichtlage eine hinreichende optische Absorption zu gewährleisten. Um eine geringe Transparenz zu erreichen, sind die Schichtlagen als mindestens zwei Cermet-Schichten mit darin eingebetteten elektrisch leitenden Partikeln, vorzugsweise metallischen Partikeln, ausgeführt.

Die in Blickrichtung des Betrachters vordere Schicht weist dabei einen vergleichsweise geringen Gehalt an elektrisch leitenden Partikeln auf. Die wesentliche Funktion der vorderen Schicht ist eine Anpassung an ihr Umgebungsmedium, wie etwa ein Substrat oder Luft und an die hintere Schicht mit dem Ziel, eine möglichst geringe Reflexion an der Grenzfläche zwischen vorderer Schicht und Umgebungsmedium beziehungsweise einer etwaigen Zwischenschicht zu erreichen. Die vordere Schicht dient somit als "Reflexionsanpassungsschicht". Ihre Dicke und die Konzentration an elektrisch leitfähigen Partikeln sind so zu einzustellen, dass die Reflexion im sichtbaren Wellenlängenbereich möglichst gering ist.

Die dem Betrachter abgewandte hintere Cermet-Schicht befindet sich unmittelbar oder mittelbar - über eine Zwischenschicht - auf der vorderen Schicht. Die hintere Schicht hat einen höheren Gehalt an elektrisch leitfähigen Partikeln als die vordere Schicht. Die wesentliche Funktion der hinteren Schicht ist eine möglichst hohe Absorption der über das transparente Substrat und die vordere Schicht einfallenden optischen Strahlung. Parameter zur Erfüllung dieser Funktion sind ihre Schichtdicke und die Konzentration an elektrisch leitfähigen Partikeln. Je größer die Schichtdicke und die Konzentration an elektrisch leitfähigen Partikeln sind, umso höher sind elektrische Leitfähigkeit und Absorptionsvermögen der hinteren Schicht. Diese Schichtparameter werden so ausgelegt, dass eine hohe Absorption der Schichtstruktur erreicht wird, ohne dass dafür eine Metallschicht erforderlich ist und so, dass die elektrische Leitfähigkeit möglichst gering bleibt.

Die hintere Schicht ist auch für die Beständigkeit der Schichtstruktur gegenüber der Umgebungsatmosphäre entscheidend. In dem Zusammenhang ist es vorteilhaft, wenn das Oxid der oberen Schicht thermodynamisch stabil ist, beispielsweise als Oxid mit stöchiometrischer Zusammensetzung vorliegt.

Die elektrisch leitfähigen Partikel bestehen aus einem Werkstoff, der sich im Vergleich zum Matrix-Werkstoff durch eine geringere Sauerstoff-Affinität auszeichnet. Denn, wie oben bereits erläutert, werden die Cermet-Schichtlagen durch DC-Sputtern eines leitfähigen oxidischen Werkstoffs hergestellt, so dass beim Sputterprozess Sauerstoff in jedem Fall zugegen ist. Um aus dem unterstöchiometrischen leitfähigen Oxid eine weniger leitfähige, dieelektrische Matrix zu erhalten, kann es sogar erforderlich sein, beim Sputtern zusätzlichen Sauerstoff zur Verfügung zu stellen. Somit bestehen die elektrisch leitfähigen Partikel aus einem anderen, "edleren" Element als demjenigen Oxid oder denjenigen Oxiden, die den jeweiligen Matrix-Werkstoff bilden.

Dieses Element muss beim Abscheiden der jeweiligen Cermetlage aus der oxidischen Matrix als elektrisch leitfähiges Partikel ausfallen können. Je nach Matrix-Material kommen beispielsweise Metalle oder Metalllegierungen auf Basis von Edelmetall, Kupfer oder Nickel in Betracht. Besonders bewährt hat sich es sich jedoch, wenn der elektrisch leitfähige Werkstoff Silber oder eine Silberbasislegierung enthält.

Edelmetall umfasst Gold, Silber und die Elemente der Platingruppe. Leitfähige Partikel aus Edelmetall, insbesondere auch aus Silber, zeichnen sich insbesondere auch dadurch aus, dass sie in der oxidischen Matrix auch bei hohen Temperaturen, wie sie beispielsweise bei Glühungen der Schicht unter Vakuum auftreten, beständig sind. Bei Silberbasislegierungen kommt Silber der größte Gewichtsanteil aller Legierungskomponenten zu. Silber ist ein vergleichsweise kostengünstiges Edelmetall. Geeignete Silberbasislegierungen sind beispielsweise solche, die für die Schichterzeugung bei optischen Speichermedien eingesetzt werden, wie AgPdCu, AgInSn, AgTi und dergleichen.

Im einfachsten Fall sind die elektrisch leitfähigen Partikel in den jeweiligen Schichten homogen verteilt. Das elektrisch leitfähige Material kann aber auch einen Konzentrationsgradienten mit einer in Hauptausbreitungsrichtung des Vektors des einfallenden Lichtes zunehmenden Konzentration zeigen.

Chrom könnte grundsätzlich ebenfalls geeignet sein, in den oben genannten Matrix-Werkstoffen in Form metallischer Partikel auszufallen. Die Schichtstruktur gemäß der Erfindung enthält jedoch - bezogen auf das Gesamtvolumen der metallischen Partikel - maximal 1% Chrom, und ist im Idealfall chromfrei.

Die vordere Schichtlage erfüllt ihre oben erläuterte Funktion als "Reflexionsanpassungsschicht" optimal, wenn in ihr die Partikel aus dem leitfähigen Werkstoff in einer Konzentration - bezogen auf das Gesamtvolumen der vorderen Schichtlage - zwischen 2 und 8 Vol.-%, vorzugsweise zwischen 4 und 6 Vol.-% vorliegen.

Ein optimaler Kompromiss zwischen möglichst hoher optischer Absorption einerseits und geringer elektrischer Leitfähigkeit (Hochohmigkeit) der hinteren Schichtlage andererseits ergibt sich, wenn in der hinteren Schichtlage die Partikel aus dem leitfähigen Werkstoff in einer mittleren Konzentration - bezogen auf das Gesamtvolumen der hinteren Schichtlage - zwischen 15 und 45 Vol.-%, vorzugsweise zwischen 20 und 35 Vol.-% vorliegen.

Mit zunehmender Konzentration an leitfähiger Phase innerhalb der Cermet-Schicht nimmt deren Leitfähigkeit zu. Bei hohen Konzentrationen oberhalb von 45 Vol.-% kann der Widerstand wegen der einsetzenden Perkolation auf kritische Werte sinken.

Mit zunehmender Dicke nimmt der elektrische Widerstand der hinteren Schichtlage ab und die Absorption nimmt zu. Im Sinne eines möglichst hohen elektrischen Widerstandes und ausreichend hohem Absorptionsvermögen hat die hintere Schichtlage eine Dicke von weniger als 200 nm, vorzugsweise im Bereich von 70 bis 100 nm.

Im Sinne einer möglichst geringen Reflexion in Gegenrichtung zum einfallenden Licht und einer guten Reflexionsanpassung an die hintere Schicht hat die vordere Schichtlage eine Dicke von weniger als 50 nm, vorzugsweise im Bereich von 20 bis 40 nm.

Im Hinblick auf möglichst geringe Herstellkosten ist die Gesamtdicke der Schichtstruktur so klein wie möglich, um eine vorgegebene maximale Transmission einzuhalten. Hierbei haben auch die Konzentration an leitfähigen Partikeln und die Dicke der hinteren Schicht Einfluss. Die entsprechend notwendige minimale Schichtdicke kann durch Versuche einfach ermittelt werden. Als Anhaltspunkt hat es sich bewährt, wenn die Gesamtdicke von vorderer Schichtlage und hinterer Schichtlage im Bereich von 80 bis 300 nm, bevorzugt im Bereich von 90 bis 200 nm liegt.

Je größer die Partikel des elektrisch leitenden Materials sind, umso ausgeprägter ist deren Streu- und Reflexionswirkung. Im Hinblick darauf ist es vorteilhaft, wenn die Partikel in der vorderen Schichtlage im Mittel kleiner sind als die der hinteren Schichtlage. Es hat sich bewährt, wenn die elektrisch leitfähigen Partikel in der vorderen Schichtlage eine Partikelgröße von weniger als 5 nm aufweisen, wobei vorzugsweise mindestens 80% der Partikel eine Partikelgröße von weniger als 3 nm aufweisen.

In dem Zusammenhang haben die elektrisch leitfähigen Partikel in der hinteren Schichtlage vorteilhafterweise eine Partikelgröße von weniger als 50 nm, wobei vorzugsweise mindestens 80% der Partikel eine Partikelgröße im Bereich von 2 bis 20 nm aufweisen.

Der Schichtwiderstand des Schichtstapels von vorderer Schichtlage und hinterer Schicht gemessen auf der Oberfläche der hinteren Schicht liegt vorzugsweise oberhalb von 1 kOhm/square, bevorzugt oberhalb von 10kOhm/square, und besonders bevorzugt bei mehr als 100kOhm/square.

Die Schichtstruktur kann auf elektronische Bauteile und Leitungen aufgebracht sein, um diese abzudecken und für den Betrachter unsichtbar zu machen. In dem Fall dienen die elektronischen Bauteile und Leitungen oder deren Platinen gleichzeitig als Träger für die Schichtstruktur, wobei die hintere Schicht dem Träger näher liegt als die vordere Schicht. Besonders bevorzugt ist eine Ausführungsform, bei der die vordere Schichtlage auf einem Substrat aus lichtdurchlässigem Werkstoff aufgebracht ist.

Hierbei liegt die vordere Schicht dem Substrat näher als die hintere Schicht. Üblicherweise handelt es sich bei dem Substrat um eine Glasplatte, die gegebenenfalls auf ihrer dem Betrachter zugewandten Außenseite mit einer Entspiegelungsschicht versehen sein kann.

Die vordere Schicht ist auf dem transparenten Substrat unmittelbar oder mittelbar - über eine weitere transparente Zwischenschicht - aufgebracht. Sie dient in dem Fall dazu, eine möglichst geringe Reflexion an der Grenzfläche zwischen vorderer Schicht und Substrat beziehungsweise einer etwaigen Zwischenschicht zu erreichen.

Es hat sich als günstig erwiesen, wenn die Schichtstruktur eine auf die Augenempfindlichkeit normierte visuelle Reflexion Rv von weniger als 5%, bevorzugt weniger als 2%, hat, berechnet aus der Gesamtreflexion unter Abzug der Reflexion von 4% am Glas-Substrat.

Die Schichtstruktur zeigt bereits bei geringen Schichtdicken um 150 nm ein Absorptionsvermögen von annähernd 100 % und ein Reflexionsvermögen von weniger als 15 %

Ausführungsbeispiel

Nachfolgend wird die Erfindung anhand einer Patentzeichnung und eines Ausführungsbeispiels näher erläutert. Im Einzelnen zeigt:

**Figur 1** eine schematische Darstellung der erfindungsgemäßen Schichtstruktur in einem Querschnitt,

**Figur 2** eine TEM-Aufnahme eines Schliffs der Schichtstruktur

**Figur 3** ein Diagramm zur spektralen Transmission gemessen auf der Substratseite, und

**Figur 4** ein Diagramm zur spektralen Reflexion gemessen auf der Substratseite.

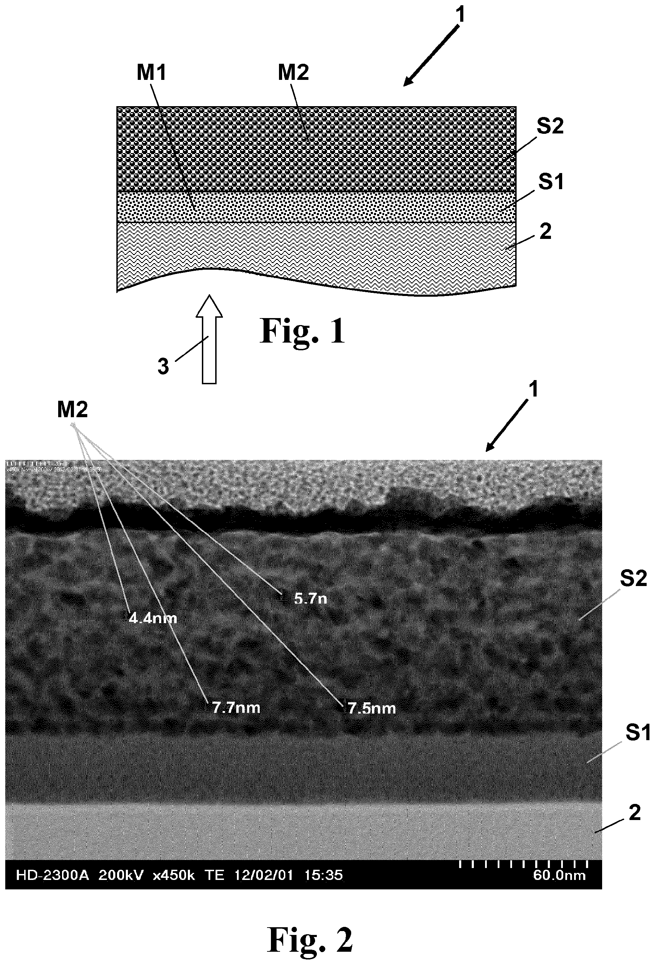

**Figur 1** zeigt schematisch ein aus zwei Cermetschichten S1, S2 bestehendes Schichtsystem 1 gemäß der Erfindung. Die erste Cermetschicht S1 ist aus einer transparenten Glasplatte 2 und auf dieser ist die zweite Cermetschicht S2 aufgebracht.

Die Cermetschichten S1 und S2 bestehen jeweils aus einer Mischung aus einer Oxidmatrix mit hoher Brechzahl und einem darin eingelagerten, weniger sauerstoff-affinen Metall. Das hochbrechende Oxid ist entweder $Nb_2O_5$ oder $TiO_2$. Das Metall ist Silber oder Kupfer.

Die Cermetschicht S1 besitzt sehr feine Metallausscheidungen M1 mit Durchmessern im Bereich bis etwa 5 nm, wobei mehr als 90% der Metallausscheidungen M1 einen Durchmesser von weniger als 3 nm haben.

Die Cermetschicht S2 besitzt gröbere Metallausscheidungen M2 mit Durchmessern im Bereich von 4 bis 10 nm, wobei über 90% der Ausscheidungen Durchmesser im Bereich von 2 bis 20 nm haben.

Das Schichtsystem 1 ist für einen Betrachter mit Blickrichtung 3 undurchsichtig.

**Figur 2** zeigt die entsprechende Schichtstruktur 1 als TEM-Aufnahme. Die Metallausscheidungen in der ersten Cermetschicht S1 sind so feinteilig, dass sie auch in dieser mikroskopischen Vergrößerung nicht aufzulösen sind. Die Metallausscheidungen M2 in der zweiten Cermetschicht S2 sind jedoch als schwarze punktförmige Bereiche zu erkennen. Einige davon sind mit Ziffern versehen, die die jeweils abgelesene Abmessung wiedergeben.

Die Metallgehalte $C_M$ und Schichtdicken d der Cermetschichten S1 und S2 bei den einzelnen Schichtsystemen, die Messwerte für die spezifische Transmission $T_V$ und die Reflexion $R_V$ (abzüglich 4% für die Reflexion der unbeschichteten Glasseite) ergeben sich aus der folgenden Tabelle.

Tabelle

| Nr. | Matrix | Metall | S1 $C_M$ [Vol-%] | S1 d [nm] | S2 $C_M$ Vol-% | S2 d [nm] | Rv [%] | Tv [%] | R□ [kΩ] | Q |
|---|---|---|---|---|---|---|---|---|---|---|
| 1 | $Nb_2O_5$ | Ag | 6 | 36 | 40 | **102** | **1,3** | **0,2** | 1,6 | |
| 2 | $Nb_2O_5$ | Ag | 6 | 36 | 30 | 103 | 1,3 | 0,4 | 226 | |
| 3 | $Nb_2O_5$ | Ag | 4 | 38 | 35 | 92 | 1,8 | 1,0 | 70 | |
| 4 | $Nb_2O_5$ | Ag | 4 | 38 | 30 | 90 | 1,8 | 1,6 | >250 | |
| 5 | $Nb_2O_5$ | Ag | 4 | 36 | 30 | 164 | 1,4 | 0,4 | 90 | |
| 6 | $Nb_2O_5$ | Ag | 6 | 37 | 20 | 88 | 1,8 | 9,4 | >250 | *) |
| 7 | $Nb_2O_5$ | Ag | 6 | 37 | 20 | 162 | 2,8 | 2,0 | >250 | |
| 8 | $Nb_2O_5$ | Ag | 6 | 37 | 15 | 87 | 1,6 | 10,6 | >250 | *) |
| 9 | $Nb_2O_5$ | Ag | 6 | 37 | 15 | 162 | 3,3 | 2,6 | >250 | |
| 10 | TiO2 | Ag | 4 | 27 | 30 | 103 | 2,2 | 2,4 | 230 | |
| 11 | TiO2 | Ag | 4 | 28 | 30 | 172 | 2,4 | 0,2 | 88 | |
| 12 | $Nb_2O_5$ | Cu | 5 | 40 | 30 | 60 | 1,3 | 17,9 | >250 | *) |
| 13 | $Nb_2O_5$ | Cu | 5 | 28 | 30 | 122 | 1,2 | 4,7 | 150 | **) |
| 14 | Nb2O5 | Cu | 5 | 33 | 30 | 167 | 1,2 | 1,6 | 125 | |
| 15 | TiO2 | Cu | 5 | 17 | 30 | 83 | 3,1 | 10,9 | >250 | **) |
| 16 | TiO2 | Cu | 5 | 21 | 30 | 129 | 3,0 | 3,4 | 145 | |
| 17 | TiO2 | Cu | 5 | 23 | 30 | 177 | 2,7 | 1,1 | 118 | |

Die Qualität der Schichtsysteme wurde hinsichtlich ihrer spektralen Reflexion $R_V$, der spektralen Transmission $T_V$ und ihres elektrischen Widerstandes R□ bewertet. Das Ergebnis ist in Spalten "Q" angegeben. Dabei setzt sich die Symbolik der qualitativen Bewertung wie folgt um:

*)              Schicht erfüllt die gestellten Anforderungen nicht
**)             Schicht mit grenzwertigen Eigenschaften
ohne Angabe:    Schicht erfüllt die gestellten Anforderungen

Nachfolgend wird ein Verfahren zur Herstellung der erfindungsgemäßen Schichtstruktur anhand eines Beispiels näher erläutert:

Eine Pulvermischung aus 94 Vol% $Nb_2O_{4,99}$ und 6 Vol% Ag mit einer mittleren Korngröße von 25 μm wird in einem Taumel-Mischer 1 h intensiv gemischt, so dass sich eine feine und monodisperse Verteilung der Ag-Partikel in $Nb_2O_{4,99}$ ergibt. Anschließend wird diese Mischung in eine Graphitform mit einem Durchmesser von 75 mm und einer Höhe von 15 mm gefüllt. Die Ronde wird durch Heißpressen unter reduzierenden Bedingungen bei 940°C und 20 MPa zu mehr als 85% der theoretischen Dichte verdichtet. Das so erhaltene Gefüge besteht aus einer $Nb_2O_{4,99}$-Matrix, in die einzelne, desagglomerierte Ag-Partikel mit einer mittleren Korngröße von 25 μm eingebettet sind.

Analog wird ein zweites Sputtertarget mit 60 Vol% $Nb_2O_{4,99}$ und 40 Vol% Ag hergestellt.

Die Sputtertargets weisen einen spezifischen elektrischen Widerstand von weniger als 1 Ohm*cm auf.

Unter Verwendung dieser Sputtertargets wird die zweilagige Schichtstruktur 1 auf einem Glassubstrat 2 (mit einem Durchmesser von 50 mm und einer Dicke von 1,0 mm) aufgebracht. Auf das Glassubstrat 2 wird zunächst eine 38 nm dicke erste Cermetschicht S1, die 6 Vol.-% Silber enthält, aufgebracht und anschließend eine 78 nm dicke zweite Cermetschicht S2, die 40 Vol.-% Silber enthält.

Die Sputterparameter sind dabei wie folgt:

Restgasdruck: 2* $10^{-6}$ mbar
Prozessdruck: 3* $10^{-3}$ mbar bei 200 sccm Argon und 1 bis 10 sccm Sauerstoff (entspricht 0,5 - 5% Sauerstoff im Sputtergas)
Spezifische Kathodenleistung: 5 W/cm$^2$

Schicht S1: Nb$_2$O$_5$ + Ag 6 vol%; d = 38 nm, zusätzlicher Sauerstoffstrom: 1 sccm.
Schicht S2: Nb$_2$O$_5$ + Ag 40 vol%; d = 90 nm, zusätzlicher Sauerstoffstrom: 10 sccm.

Die so hergestellte Schichtstruktur zeichnet sich unter anderem durch folgende Eigenschaften aus:

Schichtwiderstand: 1,3 kΩ/square
Visuelle Reflexion (nach Abzug von ca. 4% Reflexion durch Messung von der unbeschichteten Substratseite): 1,3 %.
Visuelle Transmission: kleiner als 1%, typischerweise kleiner als 0,8 %

Die Absorption der Nb$_2$O$_5$-Ag-Schichtstruktur insgesamt liegt damit höher als 97 %. Die Farbe der produzierten Schichtsysteme wird unter Zugrundelegung des CIELab- Farbraummodells ermittelt. Beim "CIELab-Farbraum" werden die gemessenen Spektralkurven auf drei Koordinaten reduziert. Die Koordinatenachsen L*, a*, b* stehen rechtwinkelig aufeinander:

L* beschreibt die Helligkeit von 0 (reines Schwarz) bis 100 (reines Weiß).

a* stellt die Rot-Grün-Achse dar. Negative Werte sind grün, positive sind rot.

b* stellt die Gelb-Blau-Achse dar. Negative Werte sind blau, positive sind gelb.

Im CIELab-Farbraum bewegt sich a* im Bereich -1,8 bis +4; und b* zwischen 0 bis -4. Somit ist mit diesem Schichtsystem eine neutrale Reflexionsfarbe auf der unbeschichteten Substratseite einstellbar.
Für die gesamte Schichtstruktur 1 wird das spektrale Reflexionsvermögens und die spektralen Transmission bei Wellenlängen von etwa 400 bis 800 nm unter Verwendung eines UV-VIS-NIR-Spektrophotometers V-570DS von JASCO gemessen. Das Absorptionsvermögen wird aus dem gemessenen Reflexionsvermögen und der gemessenen Durchlässigkeit gemäß der folgenden Gleichung berechnet:

$$\text{Absorption} = 100\% - (\text{Reflexion} + \text{Transmission})$$

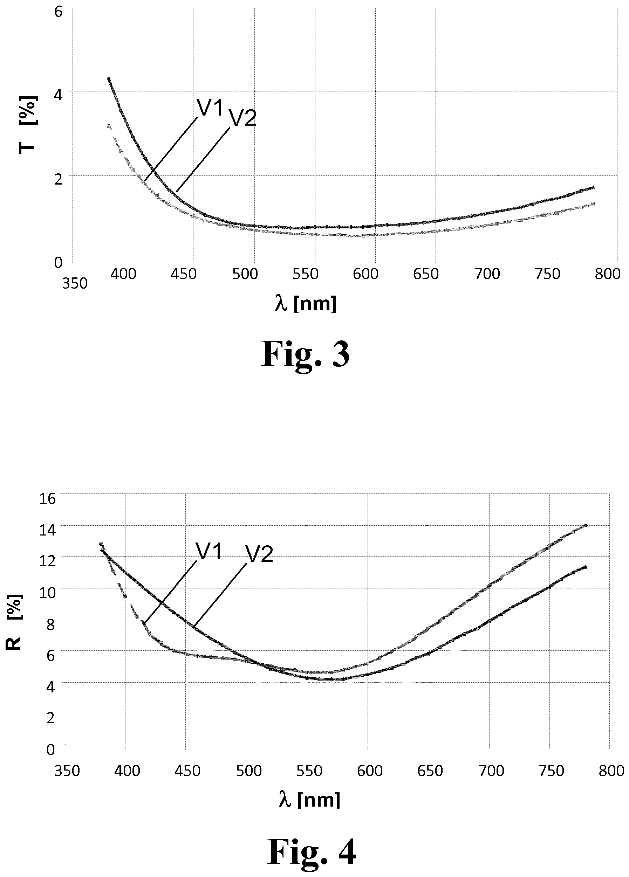

Die Figuren 3 und 4 zeigen das Absorptionsverhalten derartiger Schichtstrukturen jeweils in zwei Herstellungsvarianten:

Variante V1

Cermetschicht S1: Dicke 38 nm, Sauerstoff-Fluss beim Sputtern: 1 sccm
Cermetschicht S2: Dicke 88 nm, Sauerstoff-Fluss beim Sputtern: 10 sccm.

Variante V2

Cermetschicht S1: Dicke 35 nm, Sauerstoff-Fluss beim Sputtern: 0 sccm
Cermetschicht S2: Dicke 88 nm, Sauerstoff-Fluss beim Sputtern: 10sccm.

Der Sauerstoff-Fluss beim Sputtern wirkt sich auf die dielektrischen Eigenschaften der Oxidschicht aus. Typischerweise liegt der Sauerstoff-Fluss zwischen 0,5-10% bezogen auf den Gesamtfluss an Sputtergas. Dies ist insbesondere für die Cermetschicht S2 relevant, um eine gute Beständigkeit an Luft zu erreichen.
In **Figur 3** ist die Transmission T (in %) gegen die Messwellenlänge (in nm) aufgetragen. Demnach liegt die Transmission T über einen breiten Wellenlängenbereich von 450 nm bis 750 nm deutlich unterhalb von 2%. Die nach Variante V1 erzeugte Schichtstruktur zeigt dabei ein etwas besseres Transmissionsverhalten.
In **Figur 4** ist die Reflexion R (in %) gegen die Messwellenlänge (in nm) aufgetragen. Die Reflexion R (berechnet aus der Gesamtreflexion unter Abzug der Reflexion von 4% an der nicht entspiegelten Glasplatten-Vorderseite) liegt unterhalb von 5% über einen Wellenlängenbereich von etwa 550 nm bis 650 nm. Die nach Variante V2 erzeugte Schichtstruktur zeigt ein ausgeprägtes Minimum. Die nach Variante V1 erzeugte Schichtstruktur zeigt eine niedrigere Reflexion über einen breiteren Wellenlängenbereich.

Bei Lagerung der Schichtstruktur bei 18-24°C und 50-60% relativer Luftfeuchtigkeit über bis zu 5 Tage haben sich die optischen Eigenschaften nur unwesentlich verändert. Die Änderung von Rv und Tv lag jeweils unter einem Prozentpunkt.

Die erfindungsgemäße Schichtstruktur ist wegen ihres hohen Absorptionsvermögens und der geringen elektrischen Leitfähigkeit zur Ausbildung einer Black-Matrix-Schicht für Aktiv-Matrix getriebene Flachbildschirme geeignet.

**Patentansprüche**

1. Licht absorbierende, für einen Betrachter undurchlässig erscheinende Schichtstruktur umfassend ein dem Betrachter zugewandtes Substrat aus lichtdurchlässigem Werkstoff, eine darauf aufgebrachte vordere Schichtlage (S1) aus einer Matrix aus dielektrischem Metalloxid mit darin eingebetteten Partikeln (M1) aus elektrisch leitfähigem Werkstoff in einer ersten mittleren Konzentration, und eine auf der vorderen Schichtlage aufgebrachte dem Betrachter abgewandte hintere Schichtlage (S2) aus einer Matrix aus dem Metalloxid und darin eingebetteten Partikeln (M2) aus dem elektrisch leitfähigen Werkstoff in einer zweiten mittleren Konzentration, die höher ist als die erste mittlere Konzentration, wobei das Metalloxid Nioboxid, Molybdänoxid, Wolframoxid oder Vanadiumoxid enthält, und dass der elektrisch leitfähige Werkstoff Edelmetall, Kupfer, Nickel oder Mischungen dieser Substanzen enthält, und dass in der vorderen Schichtlage (S1) die Partikel (M1) aus dem leitfähigen Werkstoff in einer Konzentration - bezogen auf das Gesamtvolumen der vorderen Schichtlage (S1) - zwischen 2 und 8 Vol.-% vorliegen, und dass in der hinteren Schichtlage (S2) die Partikel (M2) aus dem leitfähigen Werkstoff in einer mittleren Konzentration - bezogen auf das Gesamtvolumen der hinteren Schichtlage (S2) - zwischen 15 und 45 Vol.-% vorliegen, und dass der Schichtwiderstand des Schichtstapels von vorderer Schichtlage (S1) und hinterer Schichtlage (S2) - gemessen auf der Oberfläche der hinteren Schichtlage (S2) - oberhalb von 1 kOhm/square liegt, und dass ihre auf Augenempfindlichkeit normierte visuelle Reflexion Rv - gemessen von der Substratseite - weniger als 5% beträgt, berechnet aus der Gesamtreflexion unter Abzug der Reflexion von 4% am transparenten Substrat (2), und dass ihre auf Augenempfindlichkeit normierte visuelle Transmission Tv weniger als 5% beträgt.

2. Schichtstruktur nach Anspruch 1, **dadurch gekennzeichnet, dass** der elektrisch leitfähige Werkstoff Silber oder eine Silberbasislegierung enthält.

3. Schichtstruktur nach einem der vorhergehenden Ansprüche, **dadurch gekennzeichnet, dass** der elektrisch leitfähige Werkstoff - bezogen auf das Gesamtvolumen der metallischen Partikel - maximal 1% Chrom enthält, vorzugsweise frei von Chrom ist.

4. Schichtstruktur nach einem der vorhergehenden Ansprüche, **dadurch gekennzeichnet, dass** in der vorderen Schichtlage (S1) die Partikel (M1) aus dem leitfähigen Werkstoff in einer Konzentration - bezogen auf das Gesamtvolumen der vorderen Schichtlage (S1) - zwischen 4 und 6 Vol.-% vorliegen.

5. Schichtstruktur nach einem der vorhergehenden Ansprüche, **dadurch gekennzeichnet, dass** in der hinteren Schichtlage (S2) die Partikel (M2) aus dem leitfähigen Werkstoff in einer mittleren Konzentration - bezogen auf das Gesamtvolumen der hinteren Schichtlage (S2) - zwischen 20 und 35 Vol.-% vorliegen.

6. Schichtstruktur nach einem der vorhergehenden Ansprüche, **dadurch gekennzeichnet, dass** die vordere Schichtlage (S1) eine Dicke von weniger als 50 nm, vorzugsweise im Bereich von 20 bis 40 nm hat.

7. Schichtstruktur nach einem der vorhergehenden Ansprüche, **dadurch gekennzeichnet, dass** die hintere Schichtlage (S2) eine Dicke von weniger als 200 nm, vorzugsweise im Bereich von 70 bis 100 nm hat.

8. Schichtstruktur nach einem der vorhergehenden Ansprüche, **dadurch gekennzeichnet, dass** die Gesamtdicke von vorderer Schichtlage (S1) und hinterer Schichtlage (S2) im Bereich von 80 bis 300 nm, bevorzugt im Bereich von 90 bis 200 nm liegt.

9. Schichtstruktur nach einem der vorhergehenden Ansprüche, **dadurch gekennzeichnet, dass** die elektrisch leitfähigen Partikel (M1) in der vorderen Schichtlage (S1) eine Partikelgröße von weniger als 5 nm aufweisen, wobei vorzugsweise mindestens 80% der Partikel (M1) eine Partikelgröße von weniger als 3 nm aufweisen.

10. Schichtstruktur nach einem der vorhergehenden Ansprüche, **dadurch gekennzeichnet, dass** die elektrisch leitfähigen Partikel (M2) in der hinteren Schichtlage (S2) eine Partikelgröße von weniger als 50 nm aufweisen, wobei vorzugsweise mindestens 80% der Partikel (M2) eine Partikelgröße im Bereich von 2 und 20 nm aufweisen.

11. Schichtstruktur nach einem der vorhergehenden Ansprüche, **dadurch gekennzeichnet, dass** der Schichtwiderstand von vorderer Schichtlage (S1) und hinterer Schichtlage (S2) mehr als 10kOhm/square, besonders bevorzugt mehr als 100kOhm/square beträgt.

12. Schichtstruktur nach einem der vorhergehenden Ansprüche, **dadurch gekennzeichnet, dass** ihre auf Augenempfindlichkeit normierte visuelle Reflexion Rv weniger als 2% beträgt, berechnet aus der Gesamtreflexion unter Abzug der Reflexion von 4% am transparenten Substrat (2).

13. Schichtstruktur nach einem der vorhergehenden Ansprüche, **dadurch gekennzeichnet, dass** ihre auf Augenempfindlichkeit normierte visuelle Transmission Tv weniger als 2% beträgt.

**Claims**

1. Light-absorbing layered structure that appears opaque to an observer, comprising a substrate (2) made of a transparent material facing the observer, a front sub-layer (S1) that is applied onto said substrate (2), said front sub-layer is made of a matrix of dielectric metal oxide having particles (M1) made of electrically conductive material at a first mean concentration embedded therein, and a rear sub-layer (S2) applied onto the front sub-layer (S1) and facing away from the observer, said rear sub-layer (S2) is made of a matrix made of the metal oxide and, embedded therein, particles (M2) made of the electrically conductive material at a second mean concentration that is higher than the first mean concentration, whereby the metal oxide comprises niobium oxide, molybdenum oxide, tungsten oxide or vanadium oxide, and that the electrically conductive material comprises precious metal, copper, nickel or mixtures of said substances, and that the particles (M1) made of the conductive material are present in the front sub-layer (S1) at a concentration of between 2 and 8 % by volume - relative to the total volume of the front sub-layer (S1), and that the particles (M2) made of the conductive material are present in the rear sub-layer (S2) at a mean concentration of between 15 and 45 % by volume - relative to the total volume of the rear sub-layer (S2), and that the sheet resistance of the layer stack made up by front sub-layer (S1) and rear layer (S2), is more than 1 kOhm/square - measured on the surface of the rear layer (S2), and that the visual reflection Rv of the layered structure, standardised to the sensitivity of the eye and measured on the substrate side is less than 5% - calculated from the total reflection subtracting the reflection of 4% at the transparent substrate (2), and that the visual transmission Tv of the layered structure, standardised to the sensitivity of the eye, is less than 5%.

2. Layered structure according to claim 1, **characterised in that** the electrically conductive material comprises silver or a silver-based alloy.

3. Layered structure according to any one of the preceding claims, **characterised in that** the electrically conductive material comprises maximally 1 % chromium - relative to the total volume of the metallic particles - and preferably is free of chromium.

4. Layered structure according to any one of the preceding claims, **characterised in that** the particles (M1) made of the conductive material are present in the front sub-layer (S1) at a concentration of between 4 and 6 % by volume - relative to the total volume of the front sub-layer (S1).

5. Layered structure according to any one of the preceding claims, **characterised in that** the particles (M2) made of the conductive material are present in the rear sub-layer (S2) at a mean concentration of between 20 and 35 % by volume - relative to the total volume of the rear sub-layer (S2).

6. Layered structure according to any one of the preceding claims, **characterised in that** the thickness of the front sub-layer (S1) is less than 50 nm, preferably is in the range of 20 to 40 nm.

7. Layered structure according to any one of the preceding claims, **characterised in that** the thickness of the rear sub-layer (S2) is less than 200 nm, preferably is in the range of 70 to 100 nm.

8. Layered structure according to any one of the preceding claims, **characterised in that** the total thickness of front sub-layer (S1) and rear sub-layer (S2) is in the range of 80 to 300 nm, preferably in the range of 90 to 200 nm.

9.  Layered structure according to any one of the preceding claims, **characterised in that** the particle size of the electrically conductive particles (M1) in the front sub-layer (S1) is less than 5 nm, whereby it is preferred that the particle size of at least 80% of the particles (M1) is less than 3 nm.

10. Layered structure according to any one of the preceding claims, **characterised in that** the particle size of the electrically conductive particles (M2) in the rear sub-layer (S2) is less than 50 nm, whereby it is preferred that the particle size of at least 80% of the particles (M2) is in the range of 2 to 20 nm.

11. Layered structure according to any one of the preceding claims, **characterised in that** the sheet resistance of the layer stack made up by front sub-layer (S1) and rear layer (S2), more than 10 kOhm/square, particularly preferably more than 100 kOhm/square.

12. Layered structure according to any one of the preceding claims, **characterised in that** the visual reflection Rv of the layered structure, standardised to the sensitivity of the eye, is less than 2%, calculated from the total reflection subtracting the reflection of 4% at the transparent substrate (2).

13. Layered structure according to any one of the preceding claims, **characterised in that** the visual transmission Tv of the layered structure, standardised to the sensitivity of the eye, is less than 2%.

**Revendications**

1.  Structure de couches absorbant la lumière et paraissant opaque pour l'observateur, comprenant un substrat tourné vers l'observateur en matériau translucide, une couche avant (S1) placée dessus, composée d'une matrice en oxyde métallique diélectrique avec des particules enrobées (M1) en matériau électriquement conducteur dans une première concentration moyenne et une couche arrière (S2) détournée de l'observateur et appliquée sur la couche avant, composée d'une matrice en oxyde de métal enrobant des particules (M2) en matière électriquement conductrice dans une seconde concentration moyenne qui est plus élevée que la première concentration moyenne, l'oxyde de métal contenant de l'oxyde de niobium, de l'oxyde de molybdène, de tungstène ou de vanadium et le matériau électriquement conducteur contenant du métal noble, du cuivre, du nickel ou un mélange de ces matériaux et dans la couche avant (S1) les particules (M1) en matériau conducteur se trouvant dans une concentration entre 2 et 8 % en volume - par rapport au volume total de la couche avant (S1) - et dans la couche arrière (S2), les particules (M2) en matériau conducteur se trouvant dans une concentration entre 15 et 20 % en volume - par rapport au volume totale de la couche arrière (S2) - et la résistance de la pile de couches de la couche avant (S1) et de la couche arrière (S2)- mesurée sur surface de la couche arrière (S2) - étant supérieure à 1 kOhm/carré, et sa réflexion Rv visuelle normalisée à la sensibilité de l'oeil mesurée côté substrat étant inférieure à 5 %, calculée à partir de l'ensemble de la réflexion avec soustraction de la réflexion de 4% sur le substrat transparent (2) et sa transmission Tv visuelle normalisée à la sensibilité de l'oeil étant inférieure à 5 %.

2.  Structure de couches selon la revendication 1, **caractérisée en ce que** le matériau électriquement conducteur contient de l'argent ou un alliage à base d'argent.

3.  Structure de couches selon l'une des revendications précédentes, **caractérisée en ce que** le matériau électriquement conducteur contient - par rapport au volume total de particules métalliques - au maximum 1 % de chrome et de préférence est exempt de chrome.

4.  Structure de couches selon l'une des revendications précédentes, **caractérisée en ce que** dans la couche avant (S1), les particules (M1) en matériau conducteur se trouvent dans une concentration comprise entre 4 et 6 % en volume - par rapport au volume total de la couche avant (S1).

5.  Structure de couches selon l'une des revendications précédentes, **caractérisée en ce que** dans la couche arrière (S2), les particules (M2) en matériau conducteur se trouvent dans une concentration comprise entre 20 et 35 % en volume - par rapport au volume total de la couche arrière (S2).

6.  Structure de couches selon l'une des revendications précédentes, **caractérisée en ce que** la couche avant (S1) présente une épaisseur inférieure à 50 nm, de préférence entre 20 et 40 nm.

7.  Structure de couches selon l'une des revendications précédentes, **caractérisée en ce que** la couche arrière (S2) présente une épaisseur inférieure à 200 nm, de préférence entre 70 et 100 nm.

8. Structure de couches selon l'une des revendications précédentes, **caractérisée en ce que** l'épaisseur totale de la couche avant (S1) et de la couche arrière (S2) est comprise entre 80 et 300 nm, de préférence entre 90 et 200 nm.

9. Structure de couches selon l'une des revendications précédentes, **caractérisée en ce que** les particules électriquement conductrices (M1) dans la couche avant (S1) présentent une grandeur de particules inférieure à 5 nm, de préférence au moins 80% des particules (M1) présentent une grandeur de particule inférieure à 3 nm.

10. Structure de couches selon l'une des revendications précédentes, **caractérisée en ce que** les particules électriquement conductrices (M2) dans la couche arrière (S2) présentent une grandeur de particules inférieure à 50 nm, de préférence au moins 80% des particules (M2) présentent une grandeur de particule comprise entre 2 et 20 nm.

11. Structure de couches selon l'une des revendications précédentes, **caractérisée en ce que** la résistance de la couche avant (S1) et de la couche arrière (S2) est supérieure à 10kOhm/carré, particulièrement préféré, supérieure à 100kOhm/carré.

12. Structure de couches selon l'une des revendications précédentes, **caractérisée en ce que** sa réflexion Rv visuelle normalisée à la sensibilité de l'oeil mesurée côté substrat est inférieure à 2%, calculée à partir de l'ensemble de la réflexion avec soustraction de la réflexion de 4% sur le substrat transparent (2).

13. Structure de couches selon l'une des revendications précédentes, **caractérisée en ce que** sa transmission Tv visuelle normalisée à la sensibilité de l'oeil est inférieure à 2%.

Fig. 1

Fig. 2

**Fig. 3**

**Fig. 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5976639 A
- US 6387576 B2
- US 20100313875 A1

**In der Beschreibung aufgeführte Nicht-Patentliteratur**

- **KENNEDY, C.E.** Review of Mid- to High-Temperature Solar Selective Absorber Materials. *NREL Technical Report,* Juli 2002